# EUROPEAN PATENT SPECIFICATION

(11) **EP 2 787 625 B1**
(45) Date of publication and mention of the grant of the patent: **12.07.2017**
(21) Application number: 11876647.6
(22) Date of filing: 02.12.2011
(51) Int. Cl.: H02M 1/08, H02M 7/487, H03K 17/00

(54) **POWER CONVERSION DEVICE**
STROMWANDLER
DISPOSITIF DE CONVERSION DE PUISSANCE

(43) Date of publication of application: 08.10.2014
(73) Proprietor: Mitsubishi Electric Corporation, Tokyo 100-8310 (JP)
(72) Inventor: YAMAMOTO, Kazuya, Tokyo 100-8310 (JP); KAGEYAMA, Masanori, Tokyo 100-8310 (JP); MURATA, Shinji, Tokyo 100-8310 (JP); ITO, Hiroshi, Tokyo 100-8310 (JP)
(74) Representative: Zech, Stefan Markus
(86) International application number: PCT/JP2011/077970
(87) International publication number: WO 2013/080383

(56) References cited:
- JP-A- H0 767 353
- JP-A- 2003 324 972
- JP-A- 2006 081 232
- JP-A- 2011 142 783
- JP-B1- S5 147 848
- US-A1- 2004 232 971
- US-A1- 2009 195 068

## Description

### Field

The present invention relates to a power conversion apparatus that converts direct-current power into alternating-current power with a three-level inverter system and, more particularly, to a power conversion apparatus that performs power conversion at a high voltage.

### Background

To facilitate understanding, the configuration of the power conversion apparatus of the three-level inverter system is briefly explained.

A series circuit of two capacitors having an equal capacitance value is arranged between a positive terminal and a negative terminal of a conversion target direct-current power supply. A positive electrode bus and a negative electrode bus of a switching circuit of a three-level inverter are connected to the positive terminal and the negative terminal of the conversion target direct-current power supply. Four switching elements are arranged in series between the positive electrode bus and the negative electrode bus. In an example of a three-phase output, three series circuits each of which has the four switching elements are arranged in parallel.

That is, the series circuit of the two capacitors having the equal capacitance value are charged by an output voltage of the conversion target direct-current power supply, whereby a bus voltage between the positive electrode bus and the negative electrode bus of the switching circuit of the three-level inverter is formed. The two capacitors connected in series equally share the output voltage of the direct-current power supply. Therefore, intermediate potential of the direct-current power supply is output to a connection end of the two capacitors connected in series.

A connection end of the two capacitors connected in series and a connection end of two switching elements connected in series on the positive electrode bus side are connected by a diode for upper arm clamp. A connection end of the two capacitors connected in series and a connection end of two switching elements connected in series on the negative electrode bus side are connected by a diode for lower arm clamp. Among the four switching elements connected in series, a connection end of a series circuit by the two switching elements on the positive electrode bus side and a series circuit by the two switching elements on the negative electrode bus side configures an inverter output end.

The power conversion apparatus of the three-level inverter system switches, with such a configuration, three voltage levels including, besides a power supply voltage and 0 volt, a half voltage of the power supply voltage. Therefore, the power conversion apparatus can bring a waveform of a converted output alternating-current voltage closer to a sine waveform than a power conversion apparatus of a two-level inverter system that controls switching of the power supply voltage and 0 volt.

The power conversion apparatus of the three-level inverter system is also used as a power conversion apparatus that subjects a high voltage generated by a direct-current power generating installation including a solar battery or a fuel battery to power conversion. As a direct-current power generating installation that generates a high voltage, besides, there is a direct-current power generating installation that applies a converter to an alternating-current generator such as a wind power generator or a geothermal power generator to enable the alternating-current generator to output direct-current power. As the direct-current power generating installation, there are a direct-current power generating installation used in a power generation system that interconnects with a commercial power system and a direct-current power generating installation used in a private power generation system.

In this specification, the power conversion apparatus of the three-level inverter system used as a power conditioner in a solar power generation system that can also perform system interconnection is kept in mind and explained. As the solar power generation system that can also perform the system association, there is also a system in which, for system energy efficiency improvement, a voltage is increased through an increase in the number of series connections of solar battery panels and reaches a maximum voltage DC 1000 volts.

In the power conversion apparatus of the three-level inverter system that performs power conversion at such a high voltage, a plurality of semiconductor driving circuits that respectively turn on and off a plurality of switching elements included in a switching circuit need to respectively supply driving power from driving power supplies insulated from one another. Therefore, an isolation transformer is used for each of the semiconductor driving circuits. However, when a direct-current voltage generated by a solar battery panel reaches a high voltage, corona discharge occurs between a primary winding and a secondary winding of the isolation transformer and deteriorates the isolation transformer. Therefore, a withstand voltage needs to be designed for the isolation transformer taking into account the corona discharge to secure reliability. A reduction in costs and a reduction in size are difficult.

As a preceding example for realizing a reduction in insulation, for example, Patent Literature 1 proposes a method of, because the potential at a connection end of two capacitors connected in series gives intermediate potential of an output direct-current voltage of a solar battery panel, connecting the connection end of the two capacitors connected in series and a housing case and fixing reference potentials of a control circuit and a control power supply to the direct-current intermediate potential. Thus, withstand voltage values between a power conversion apparatus and the housing case and among apparatuses are reduced.

### Citation List

### Patent Literature

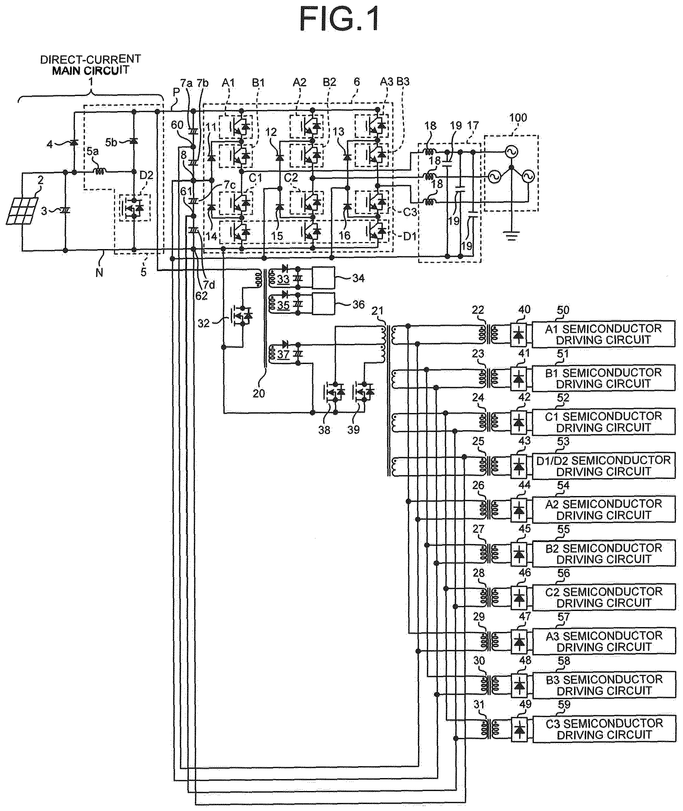

Patent Literature 1: JP 2003 324972 A is considered to be the prior art closest to the subject matter of independent apparatus claim 1 and discloses in figure 1 a power conversion apparatus comprising: two main circuit capacitors *(**Figure 1**: (13), (14) )* connected in series between a positive terminal side *(**Figure 1**: (P) )* and a negative terminal side *(**Figure 1**: (N) )* of a direct-current main circuit to equally share a conversion target direct-current voltage output by the direct-current main circuit to equally divide the direct-current voltage into two; a three-level inverter switching circuit *(**Figure 1**: (15) )* including at least one unit configuration, the unit configuration including; four switching elements connected in series between a positive electrode bus *(**Figure 1**: (P) )* and a negative electrode bus *(**Figure 1**: (N) )* connected to a positive terminal side and a negative terminal side of a series circuit of the two main circuit capacitors, and between the four switching elements and the two main circuit capacitors, a diode for upper arm clamp arranged between a connection end *(**Figure 1**: (M) )* of series circuits of a main circuit capacitor on the positive electrode bus side *(**Figure 1**: (13) )* and the negative electrode bus side *(**Figure 1**: (14) )* and a connection end of two switching elements connected in series on the positive electrode bus side, and a diode for lower arm clamp arranged between the connection end *(**Figure 1**: (M) )* of the series circuits of a main circuit capacitor on the positive electrode bus side *(**Figure 1**: (13) )* and the negative electrode bus side *(**Figure 1**: (14) )* and a connection end of two switching elements connected in series on the negative electrode bus side, a connection end of series circuits formed by two switching elements on the positive electrode bus side and the negative electrode bus side being formed as an inverter output end;
Patent Literature 2: US 2009 195068 A1
Patent Literature 3: JP 2006 081232 A
Patent Literature 4: US 2004 232971 A1

### Summary

### Technical Problem

However, in the technology described in Patent Literature 1, reference potential of a semiconductor driving circuit is fixed to the potential at the connection end of the two capacitors connected in series (the direct-current intermediate potential). Therefore, a withstand voltage between a primary winding and a secondary winding of an isolation transformer provided for each of semiconductor driving circuits is not equal to or lower than the direct-current intermediate potential. When application in a system in which a generated direct-current voltage of a solar battery panel reaches a maximum voltage DC 1000 volts is taken into account, the potential at the connection end of the two capacitors connected in series reaches DC 500 volts. According to the Paschen's law, because corona discharge occurs when the potential between the primary winding and the secondary winding of the isolation transformer is equal to or higher than DC 330 volts, the potential of DC 500 volts is potential at which the corona discharge occurs. Accordingly, with the technology described in Patent Literature 1, the problem cannot be solved. A withstand voltage needs to be designed for the isolation transformer taking into account the corona discharge as in the past.

The present invention has been devised in view of the above and it is an object of the present invention to obtain a power conversion apparatus that can reduce a withstand voltage of an isolation transformer for a semiconductor driving circuit and secure long-term reliability under a situation in which a conversion target power supply voltage reaches a high voltage.

### Solution to Problem

To solve the problem and attain the object, the present invention provides a power conversion apparatus including: four main circuit capacitors connected in series between a positive electrode side and a negative electrode side of a direct-current main circuit, which outputs a conversion target direct-current voltage, to share the direct-current voltage to equally divide the direct-current voltage into four; a three-level inverter switching circuit including at least one unit configuration, the unit configuration being configured by four switching elements connected in series between a positive electrode bus and a negative electrode bus connected to a positive terminal side and a negative terminal side of a series circuit of the four main circuit capacitors, an inverter output end of which is formed at a connection end of series circuits formed by two switching elements on the positive electrode bus side and the negative electrode bus side, and a diode for upper arm clamp arranged between a connection end of series circuits of two main circuit capacitors on the positive electrode bus side and the negative electrode bus side and a connection end of two switching elements connected in series on the positive electrode bus side and a diode for lower arm clamp arranged between the connection end of the series circuits of the two main circuit capacitors on the positive electrode bus side and the negative electrode bus side and a connection end of two switching elements connected in series on the negative electrode bus side between the four switching elements and the four main circuit capacitors; a plurality of semiconductor driving circuits configured to drive a plurality of the switching elements in the three-level inverter switching circuit, one semiconductor driving circuit for the switching element, one signal terminal of which is connected to the negative electrode bus, among the four switching elements in the unit configuration being provided in common even if a plurality of the unit configurations are provided and the semiconductor driving circuits for second to fourth switching elements from the negative electrode bus to the positive electrode bus being individually provided in a one-to-one relation even if a plurality of the unit configurations are provided; a plurality of isolation transformers provided in a one-to-one relation with each of the plurality of semiconductor driving circuits, the semiconductor driving circuits corresponding to a secondary winding of each of the isolation transformers among the plurality of semiconductor driving circuits being connected to the secondary winding via a rectifier circuit; a flyback transformer, to a primary winding of which a pulse voltage obtained by switching an output voltage of the direct-current main circuit formed by a series circuit of the four main circuit capacitors is applied; and an inverter transformer including a primary winding and four secondary windings, a pulse voltage obtained by switching an output voltage of one rectifier circuit among rectifier circuits respectively connected to a plurality of secondary windings of the flyback transformer being applied to the primary winding and a primary winding of at least one of the isolation transformers being connected to each of the four secondary windings. As reference potentials of the plurality of semiconductor driving circuits, reference potential of a semiconductor driving circuit for a switching element, one signal terminal of which is connected to the negative electrode bus, among the four switching elements in the unit configuration is the potential of the negative electrode bus. Reference potential of a semiconductor driving circuit for the second switching element from the negative electrode bus to the positive electrode bus is the potential at a connection end of two main circuit capacitors connected in series on the negative electrode bus side among the four main circuit capacitors. Reference potential of a semiconductor driving circuit for the third switching element from the negative electrode bus to the positive electrode bus is the potential at a connection end of a series circuit of two main circuit capacitors connected in series on the positive electrode bus side and a series circuit of two main circuit capacitors connected in series on the negative electrode bus side among the four main circuit capacitors. Reference potential of a semiconductor driving circuit for the fourth switching element from the negative electrode bus to the positive electrode bus is the potential at a connection end of two main circuit capacitors connected in series on the positive electrode bus side among the four main circuit capacitors. A connection end of the negative terminal side and the negative electrode bus of the series circuit of the four main circuit capacitors is connected to one end of a primary winding of the isolation transformer corresponding to a semiconductor driving circuit for a switching element, one signal terminal of which is connected to the negative electrode bus, among the four switching elements in the unit configuration. A connection end of the two main circuit capacitors connected in series on the negative electrode bus side among the four main circuit capacitors is connected to one end of a primary winding of the isolation transformer corresponding to the semiconductor driving circuit for the second switching element from the negative electrode bus to the positive electrode bus among the four switching elements in the unit configuration. A connection end of the series circuits of the two main circuit capacitors connected in series on the positive electrode bus side and the negative electrode bus side among the four main circuit capacitors is connected to one end of the primary winding of the isolation transformer corresponding to the semiconductor driving circuit for the third switching element from the negative electrode bus to the positive electrode bus among the four switching elements in the unit configuration. A connection end of the two main circuit capacitors connected in series on the positive electrode bus side among the four main circuit capacitors is connected to one end of the primary winding of the isolation transformer corresponding to the semiconductor driving circuit for the fourth switching element from the negative electrode bus to the positive electrode bus among the four switching elements in the unit configuration.

### Advantageous Effects of Invention

According to the present invention, both of the reference potentials of the semiconductor driving circuits, and the reference potentials between primary sides of the isolation transformers for supplying isolated direct-current power to the semiconductor driving circuits corresponding to the isolation transformers and a secondary side of the inverter transformer, are supplied from the respective same connection ends among the connection ends of the four main circuit capacitors. Therefore, a potential difference of reference potential between primary sides and secondary sides of the plurality of isolation transformers is 0 volt even if a conversion target power supply voltage reaches a high voltage such as DC 1000 volts. Therefore, even under a situation in which a conversion target power supply voltage reaches a high voltage such as DC 1000 volts, corona discharge does not occur between the primary sides and the secondary sides of the isolation transformers. Accordingly, insulation deterioration does not occur and long-term reliability of the isolation transformers is improved. Further, because design for the isolation transformers that takes into account a withstand voltage can be substantially relaxed, there is an effect that it is possible to realize a reduction in costs and a reduction in size.

### Brief Description of Drawings

FIG. 1 is a block diagram of the configuration of a power conversion apparatus according to an embodiment of the present invention.

### Description of Embodiments

An embodiment of a power conversion apparatus according to the present invention is explained in detail below with reference to the drawings. Note that the present invention is not limited by the embodiment.

### Embodiment

Fig. 1 is a block diagram of the configuration of a power conversion apparatus according to an embodiment of the present invention. Note that, in Fig. 1, a configuration example in which the present invention is applied to a power conversion apparatus (a power conditioner) of a three-level inverter system used in a solar power generation system that interconnects with a commercial power system 100 of a three-phase four-wire system is shown.

In Fig. 1, a direct-current main circuit 1 generates a conversion target direct-current voltage (e.g., DC 1000 volts) between a positive electrode line P and a negative electrode line N. The direct-current main circuit 1 includes a solar battery panel 2, a main circuit capacitor 3, a bypass diode 4, and a boost chopper 5. The negative electrode line N of the direct-current main circuit 1 is connected to a negative terminal of the solar battery panel 2.

The solar battery panel 2 is a direct-current power generating installation that receives sunlight and generates a direct-current voltage. The main circuit capacitor 3 is arranged between a positive terminal and the negative terminal (the negative electrode line N of the direct-current main circuit 1) of the solar battery panel 2 and serves to smooth and retain an output voltage of the solar battery panel 2. The output voltage of the solar battery panel 2 fluctuates according to environmental conditions such as sunshine and humidity. Therefore, the bypass diode 4 and the boost chopper 5 are arranged in parallel between the positive and the negative terminals of the solar battery panel 2 and the positive and the negative electrode lines P and N of the direct-current main circuit 1.

An anode terminal of the bypass diode 4 is connected to a positive terminal of the solar battery panel 2. A cathode terminal of the bypass diode 4 is connected to a positive electrode line P of the direct-current main circuit 1. The boost chopper 5 includes a reactor 5a, a switching element D2, and a reverse-flow blocking diode 5b. One end of the reactor 5a is connected to the positive terminal of the solar battery panel 2. The other end of the reactor 5a is connected to a connection end of one signal terminal of the switching element D2 and an anode terminal of the reverse-flow blocking diode 5b. The other signal terminal of the switching element D2 is connected to the negative electrode line N. A cathode terminal of the reverse-flow blocking diode 5b is connected to the positive electrode line P. Note that the switching element D2 is, for example, an IGBT. A reflux diode is connected in reverse parallel to the switching element D2.

The positive electrode line P and the negative electrode line N of the direct-current main circuit 1 respectively form a positive electrode bus and a negative electrode bus of a three-level inverter switching circuit 6. Four main circuit capacitors 7a, 7b, 7c, and 7d are arranged in series between the positive electrode line P and the negative electrode line N instead of the two main circuit capacitors connected in series in the past. Capacitance values of the four main circuit capacitors 7a to 7d are the same to each other.

That is, a series circuit of the four main circuit capacitors 7a to 7d smoothes and retains a direct-current voltage output to between the positive electrode line P and the negative electrode line N by the direct-current main circuit 1, whereby a bus voltage between the positive electrode bus and the negative electrode bus of a three-level inverter switching circuit 6 is formed. At this point, the respective main circuit capacitors 7a to 7d act to equally divide the direct-current voltage output to between the positive electrode line P and the negative electrode line N by the direct-current main circuit 1 into four.

The three-level inverter switching circuit 6 shown in Fig. 1 has a three-phase output configuration. Three sets (A1, B1, C1, and D1), (A2, B2, C2, and D1), and

(A3, D3, C3, and D1), each set including four switching elements connected in series, are connected in parallel between the positive electrode line P and the negative electrode line N that form the positive electrode bus and the negative electrode bus, respectively. Note that all of the switching elements A1, B1, C1, D1, A2, B2, C2, D1, A3, B3, C3, and D1 are, for example, IGBTs. Reflux diodes are connected in reverse parallel to the switching elements.

Diodes for clamp 11, 12, and 13 are respectively arranged between a connection end 8 of a series circuit of the main circuit capacitors 7a and 7b, which are connected in series on the positive electrode line P side, and a series circuit of the main circuit capacitors 7c and 7d, which are connected in series on the negative electrode line N side, and connection ends of the respective three sets (A1 and B1), (A2 and B2), and (A3 and B3) of the two switching elements connected in series on the positive electrode line P side. Diodes for clamp 14, 15, and 16 are respectively arranged between the connection end 8 and connection ends of the respective three sets (C1 and D1), (C2 and D1), (C3 and D1) of the two switching elements connected in series on the negative electrode line N side.

In the three sets (A1, B1, C1, and D1), (A2, B2, C2, and D1), and (A3, B3, C3, and D1) of the four switching elements connected in series, a connection end of the switching elements B1 and C1, a connection end of the switching elements B2 and C2, and a connection end of the switching elements B3 and C3 respectively form output ends and are connected to a commercial power system 100 of the three-phase four-wire type via a reactor AC filter 17. Note that the AC filter 17 includes reactors 18 arranged between the respective output ends of the three-level inverter switching circuit 6 and the commercial power system 100, and capacitors 19 arranged between the respective reactors 18 and the connection end 8. That is, reference potential of the AC filter 17 is the potential of the connection end 8 (intermediate potential of a direct-current voltage generated by the direct-current main circuit 1). A neutral point of the commercial power system 100 is directly grounded to the earth.

A control power supply configured to supply direct-current power to a control system of the three-level inverter system power conversion apparatus is formed via a flyback transformer 20, an inverter transformer 21, and pulse transformers 22 to 31, which are isolation transformers.

In the flyback transformer 20, for example, three secondary windings are provided with respect to a primary winding. A winding start end of the primary winding of the flyback transformer 20 is connected to the negative electrode line N via a switching element 32. A winding finish end of the primary winding is connected to the positive electrode line P. Among the three secondary windings of the flyback transformer 20, a power supply for analog circuit 34 is connected to the first secondary winding via a rectifier circuit 33. A power supply for digital circuit 36 is connected to the second secondary winding via a rectifier circuit 35. A primary side of the inverter transformer 21 is connected to the third secondary winding via a rectifier circuit 37. Note that the switching element 32 is, for example, an IGBT. A reflux diode is connected in reverse parallel to the switching element 32.

In the inverter transformer 21, a primary winding is attached with an intermediate tap. For example, four secondary windings are provided with respect to the primary winding. The intermediate tap of the primary winding of the inverter transformer 21 is connected to a positive terminal of the rectifier circuit 37. One winding start end and the other winding start end of the primary winding are connected to the negative electrode line N respectively via a switching element 38 and a switching element 39 together with a negative terminal of the rectifier circuit 37. Note that both of the switching elements 38 and 39 are, for example, IGBTs. Reflux diodes are connected in reverse parallel to the switching elements 38 and 39.

In the four secondary windings of the inverter transformer 21, primary windings of the pulse transformers 22, 26, and 29 are connected in parallel and connected to the first secondary winding. Primary windings of the pulse transformers 23, 27, and 30 are connected in parallel and connected to the second secondary winding. Primary windings of the pulse transformers 24, 28, and 31 are connected in parallel and connected to the third secondary winding. A primary winding of one pulse transformer 25 is connected to the fourth secondary winding.

Each of the pulse transformers 22 to 31, which are the isolation transformers, has one secondary winding with respect to one primary winding. An A1 semiconductor driving circuit 50, an A2 semiconductor driving circuit 54, and an A3 semiconductor driving circuit 57 respectively configured to drive switching elements A1, A2, and A3 are respectively connected to the secondary windings of the pulse transformers 22, 26, and 29 via rectifier circuits 40, 44, and 47. A B1 semiconductor driving circuit 51, a B2 semiconductor driving circuit 55, and a B3 semiconductor driving circuit 58 respectively configured to drive switching elements B1, B2, and B3 are respectively connected to the secondary windings of the pulse transformers 23, 27, and 30 via rectifier circuits 41, 45, and 48. A C1 semiconductor driving circuit 52, a C2 semiconductor driving circuit 56, and a C3 semiconductor driving circuit 59 respectively configured to drive switching elements C1, C2, and C3 are respectively connected to the secondary windings of the pulse transformers 24, 28, and 31 via rectifier circuits 42, 46, and 49. A D1/D2 semiconductor driving circuit 53 configured to drive switching elements D1 and D2 is connected to the secondary winding of the pulse transformers 25 via a rectifier circuit 43.

In the configuration explained above, , among the four main circuit capacitors 7a to 7d connected in series between the positive electrode line P and the negative electrode line N, a connection end 60 of the main circuit capacitors 7a and 7b is connected to a connection line of a winding finish end of the first secondary winding of the inverter transformer 21 and a winding finish end of the primary winding of the pulse transformer 22. A connection end 8 of the main circuit capacitors 7b and 7c is connected to a connection line of a winding finish end of the second secondary winding of the inverter transformer 21 and a winding finish end of the primary winding of the pulse transformer 23. A connection end 61 of the main circuit capacitors 7c and 7d is connected to a connection line of a winding finish end of the third secondary winding of the inverter transformer 21 and a winding finish end of the primary winding of the pulse transformer 24. A connection end 62 of the main circuit capacitor 7d and the negative electrode line N is connected to a connection line of a winding finish end of the fourth secondary winding of the inverter transformer 21 and a winding finish end of the primary winding of the pulse transformer 25.

Although connection relations are not shown in the figure, reference potentials of the A1 semiconductor driving circuit 50, the A2 semiconductor driving circuit 54, and the A3 semiconductor driving circuit 57 are the potential at the connection end 60 of the main circuit capacitors 7a and 7b. Reference potentials of the B1 semiconductor driving circuit 51, the B2 semiconductor driving circuit 55, and the B3 semiconductor driving circuit 58 are the potential at the connection end 8 of the main circuit capacitors 7b and 7c. Reference potentials of the C1 semiconductor driving circuit 52, the C2 semiconductor driving circuit 56, and the C3 semiconductor driving circuit 59 are the potential at the connection end 61 of the main circuit capacitors 7c and 7d. Reference potential of the D1/D2 semiconductor driving circuit 53 is the potential at the connection end 62 of the main circuit capacitor 7d and the negative electrode line N.

An operation is explained. During the start or the like of the solar power generation system, the switching element D2 is off and the boost chopper 5 stops a boosting operation. Therefore, a direct-current voltage generated by the solar battery panel 2 is output to between the positive electrode line P and the negative electrode line N via the bypass diode 4, and applied to a series circuit of the main circuit capacitors 7a to 7d. The series circuit of the main circuit capacitors 7a to 7d is charged. A charging voltage of the series circuit rises to the direct-current voltage generated by the solar battery panel 2.

When the voltage of the series circuit of the main circuit capacitors 7a to 7d rises to a predetermined voltage, the switching element 32 starts an ON/OFF operation. Alternating-current voltages are generated in the respective three secondary windings of the flyback transformer 20. The alternating-current voltage generated in the first secondary winding is rectified and smoothed by the rectifier circuit 33 and supplied to the power supply for analog circuit 34. The alternating-current voltage generated in the second secondary winding is rectified and smoothed by the rectifier circuit 35 and supplied to the power supply for digital circuit 36. The alternating-current voltage generated in the third secondary side winding is rectified and smoothed by the rectifier circuit 37 and supplied to the primary side of the inverter transformer 21.

On the primary side of the inverter transformer 21, the two switching elements 38 and 39 alternately perform an ON/OFF operation, whereby alternating-current voltages are supplied from the four secondary windings of the inverter transformer 21 to the pulse transformers 22 to 31 in parallel.

The alternating-current voltage supplied to the pulse transformer 22 is changed to an isolated direct-current voltage by the rectifier circuit 40 and supplied to the A1 semiconductor driving circuit 50. The alternating-current voltage supplied to the pulse transformer 23 is changed to an isolated direct-current voltage by the rectifier circuit 41 and supplied to the B1 semiconductor driving circuit 51. The alternating-current voltage supplied to the pulse transformer 24 is changed to an isolated direct-current voltage by the rectifier circuit 42 and supplied to the C1 semiconductor driving circuit 52. The alternating-current voltage supplied to the pulse transformer 25 is changed to an isolated direct-current voltage by the rectifier circuit 43 and supplied to the D1/D2 semiconductor driving circuit 53. The alternating-current voltage supplied to the pulse transformer 26 is changed to an isolated direct-current voltage by the rectifier circuit 44 and supplied to the A2 semiconductor driving circuit 54.

The alternating-current voltage supplied to the pulse transformer 27 is changed to an isolated direct-current voltage by the rectifier circuit 45 and supplied to the B2 semiconductor driving circuit 55. The alternating-current voltage supplied to the pulse transformer 28 is changed to an isolated direct-current voltage by the rectifier circuit 46 and supplied to the C2 semiconductor driving circuit 56. The alternating-current voltage supplied to the pulse transformer 29 is changed to an isolated direct-current voltage by the rectifier circuit 47 and supplied to the A3 semiconductor driving circuit 57. The alternating-current voltage supplied to the pulse transformer 30 is changed to an isolated direct-current voltage by the rectifier circuit 48 and supplied to the B3 semiconductor driving circuit 58. The alternating-current voltage supplied to the pulse transformer 31 is changed to an isolated direct-current voltage by the rectifier circuit 49 and supplied to the C3 semiconductor driving circuit 59.

When electric power is supplied to the semiconductor driving circuits 50 to 59, a direct-current voltage generated by the solar battery panel 2 is boosted to a set voltage by the boost chopper 5. The series circuit of the main circuit capacitors 7a and 7b is charged. When the direct-current voltage generated by the solar battery panel 2 rises to be higher than the set potential, the boost chopper 5 stops the operation. The series circuit of the main circuit capacitors 7a and 7b is charged via the bypass diode 4.

The three-level inverter switching circuit 6 switches a direct-current voltage (a bus voltage), the potential (=0 volt) of the negative electrode line N, and intermediate potential (a half voltage of the power supply voltage), generates an alternating-current voltage, and supplies synchronized alternating-current power to the commercial power system 100 through the AC filter 17. The direct-current voltage formed by the series circuit of the main circuit capacitors 7a to 7d is a power supply voltage output to between the positive electrode line P and the negative electrode line N by the direct-current main circuit 1. The intermediate potential is output to a connection point 8 in the series circuit of the main circuit capacitors 7a and 7b.

When the direct-current voltage generated by the solar battery panel 2 is, for example, a maximum voltage DC 1000 volts, in the series circuit of the main circuit capacitors 7a to 7d, the respective main circuit capacitors 7a to 7d equally share the maximum voltage of 1000 volts. Therefore, a voltage DC 250 volts is applied to the respective main circuit capacitors 7a to 7d. Therefore, the intermediate potential output to the connection end 8 is a half voltage 500 volts of the power supply voltage DC 1000 volts. The same holds true in the three-level inverter system power conversion apparatus in the past in which the two main circuit capacitors arranged between the positive electrode line P and the negative electrode line N of the direct-current main circuit 1 are connected in series.

In such a three-level inverter system power conversion apparatus in the past, as described in Patent Literature 1, the reference potentials of the control circuit, the control power supply, and the semiconductor driving circuit are connected to the intermediate potential of the output voltage of the direct-current main circuit. Therefore, a potential difference of a voltage between the primary side and the secondary side of the pulse transformer, which is necessary for the supply of isolated direct-current power to the semiconductor driving circuit, does not decrease to be lower than DC 500 volts, which is the intermediate potential. According to the Paschen's law, potential at which corona discharge occurs between the primary side and the secondary side of the pulse transformer is equal to or higher than DC 330 volts. Therefore, when a conversion target power supply voltage reaches a high voltage such as DC 1000 volts, in the past, to avoid insulation deterioration of the pulse transformer, it is necessary to perform design taking into account a withstand voltage. Therefore, an increase in costs is caused and a reduction in size is difficult.

In the three-level inverter system power conversion apparatus in the past, the connection line of the winding finish end of the secondary winding of the inverter transformer 21 and the winding finish ends of the primary windings of the pulse transformers is in a floating state. Therefore, the connection line is easily affected by noise due to parasitic capacitance of the inverter transformer and parasitic capacitance of the pulse transformers. It is concerned that the three-level inverter switching circuit 6 is likely to malfunction.

According to this embodiment, these two problems are simultaneously solved.

First, concerning the first problem, both of reference potentials of the semiconductor driving circuits, and reference potentials between the primary sides of the pulse transformers for supplying isolated direct-current power to the semiconductor driving circuits corresponding to the pulse transformers and the secondary side of the inverter transformer, are supplied from the respective same connection ends among the connection ends 60, 8, 61, and 62 of the main circuit capacitors 7a to 7d.

Specifically, reference potentials of the A1 semiconductor driving circuit 50, the A2 semiconductor driving circuit 54, and the A3 semiconductor driving circuit 57 configured to respectively drive the switching elements A1, A2, and A3 are the potential at the connection end 60 in the series circuit of the main circuit capacitors 7a to 7b. A connection line of winding finish ends of the primary windings of the pulse transformers 22, 26, and 29 configured to supply isolated direct-current power to the respective semiconductor driving circuits and a winding finish end of the first secondary winding of the inverter transformer 21 corresponding to the pulse transformers is connected to the connection end 60.

Reference potentials of the B1 semiconductor driving circuit 51, the B2 semiconductor driving circuit 55, and the B3 semiconductor driving circuit 58 configured to respectively drive the next switching elements B1, B2, and B3 are the potential at the connection end 8 in the series circuit of the main circuit capacitors 7b to 7c. A connection line of winding finish ends of the primary windings of the pulse transformers 23, 27, and 30 configured to supply isolated direct-current power to the respective semiconductor driving circuits and a winding finish end of the second secondary winding of the inverter transformer 21 corresponding to the pulse transformers is connected to the connection terminal 8.

Reference potentials of the C1 semiconductor driving circuit 52, the C2 semiconductor driving circuit 56, and the C3 semiconductor driving circuit 59 configured to respectively drive the next switching elements C1, C2, and C3 are the potential at the connection end 61 in the series circuit of the main circuit capacitors 7c and 7d. A connection line of winding finish ends of the primary windings of the pulse transformers 24, 28, and 31 configured to supply isolated direct-current power to the respective semiconductor driving circuits and a winding finish end of the third secondary winding of the inverter transformers 21 corresponding to the pulse transformers is connected to the connection terminal 61.

Reference potential of the D1/D2 semiconductor driving circuit 53 configured to drive the next switching elements D1 and D2 is the potential of the connection end 62 (the potential = 0V of the negative electrode line N) in the series circuit of the main circuit capacitors 7a to 7d. A connection line of a winding finish end of the primary winding of the pulse transformer 25 configured to supply isolated direct-current power to the D1/D2 semiconductor driving circuit 53, and a winding finish end of the fourth secondary winding of the inverter transformer 21 corresponding to the pulse transformer 25, is connected to the connection end 62.

Therefore, a potential difference of reference potential between the primary sides and the secondary sides of the pulse transformers 22 to 31 is 0 volt even if a conversion target power supply voltage reaches a high voltage such as DC 1000 volts. Accordingly, even under a situation in which a conversion target power supply voltage reaches a high voltage such as DC 1000 volts, because corona discharge does not occur between the primary sides and the secondary sides of the pulse transformers 22 to 31, insulation deterioration does not occur and long-term reliability of the pulse transformers 22 to 31 is improved. Further, because design for the pulse transformers 22 to 31 that takes into account a withstand voltage can be substantially relaxed, it is possible to realize a reduction in costs and a reduction in size.

Concerning the second problem, a connection line of a winding finish end of the secondary winding of the inverter transformer 21 and a winding finish ends of each primary winding of the pulse transformer is grounded via a capacitor, whereby noise due to parasitic capacitance of the inverter transformer and parasitic capacitance of the pulse transformers can be reduced. Therefore, there is also an effect that it is possible to prevent a malfunction of the three-level inverter switching circuit 6.

### Industrial Applicability

As explained above, the power conversion apparatus according to the present invention is useful as a power conversion apparatus of the three-level inverter system that can reduce a withstand voltage of an isolation transformer for a semiconductor driving circuit and secure long-term reliability under a situation in which a conversion target power supply voltage reaches a high voltage.

### Reference Signs List

1 Direct-current main circuit
2 Solar battery panel (Direct-current power generating installation)
3 Main circuit capacitor
4 Bypass diode
5 Boost chopper
5a Reactor
5b Reverse-flow blocking diode
6 Three-level inverter switching circuit
7a, 7b, 7c, 7d Main circuit capacitor
8, 60, 61, 62 Connection end
11 to 16 Diodes for clamp
17 AC filter
18 Reactor
19 Capacitor
20 Flyback transformer
21 Inverter transformer
22 to 31 Pulse transformer (Isolation transformers)
32, 38, 39 Switching element
33, 35, 37, 40 to 49 Rectifier circuit
34 Power supply for analog circuit
36 Power supply for digital circuit
50 A1 semiconductor driving circuit
51 B1 semiconductor driving circuit
52 C1 semiconductor driving circuit
53 D1/D2 semiconductor driving circuit
54 A2 semiconductor driving circuit
55 B2 semiconductor driving circuit
56 C2 semiconductor driving circuit
57 A3 semiconductor driving circuit
58 B3 semiconductor driving circuit
59 C3 semiconductor driving circuit
A1 to A3, B1 to B3, C1 to C3, D1, D2 Switching element

## Claims

1. A power conversion apparatus comprising:
four main circuit capacitors (7a to 7d) connected in series between a positive terminal side and a negative terminal side of a direct-current main circuit (1) to equally share a conversion target direct-current voltage output by the direct-current main circuit (1) to equally divide the direct-current voltage into four;
a three-level inverter switching circuit (6) including at least one unit configuration, the unit configuration including;
four switching elements (A1, B1, C1, D1; A2, B2, C2, D1; A3, B3, C3, D1) connected in series between a positive electrode bus (P) and a negative electrode bus (N) connected to a positive terminal side and a negative terminal side of a series circuit of the four main circuit capacitors (7a to 7d), and between the four switching elements and the four main circuit capacitors,
a diode for upper arm clamp (11; 12; 13) arranged between a connection end (8) of series circuits of two main circuit capacitors on the positive electrode bus side (7a, 7b) and the negative electrode bus side (7c, 7d) and a connection end of two switching elements (A1, B1; A2, B2; A3, B3) connected in series on the positive electrode bus side, and
a diode for lower arm clamp (14; 15; 16) arranged between the connection end (8) of the series circuits of the two main circuit capacitors on the positive electrode bus side (7a, 7b) and the negative electrode bus side (7c, 7d) and a connection end of two switching elements (C1, D1; C2, D1; C3, D1) connected in series on the negative electrode bus side,
a connection end of series circuits formed by two switching elements (B1, C1; B2, C2; B3, C3) on the positive electrode bus side and the negative electrode bus side being formed as an inverter output end;
a plurality of semiconductor driving circuits (50 to 59) configured to drive a plurality of the switching elements in the three-level inverter switching circuit (6), one semiconductor driving circuit (53) for the switching element (D1), one signal terminal of which is connected to the negative electrode bus (N), among the four switching elements in the unit configuration being provided in common even if a plurality of the unit configurations are provided, and the semiconductor driving circuits (50, 51, 52; 54, 55, 56; 57, 58, 59) for second to fourth switching elements (A1, B1, C1; A2, B2, C2; A3, B3, C3) from the negative electrode bus to the positive electrode bus being individually provided in a one-to-one relation even if a plurality of the unit configurations are provided;
a plurality of pulse transformers (22 to 31), which are isolation transformers, provided in a one-to-one relation with each of the plurality of semiconductor driving circuits (50 to 59), each of the semiconductor driving circuits (50 to 59) corresponding to a secondary winding of each of the isolation transformers among the plurality of semiconductor driving circuits (50 to 59) being connected to the secondary winding via a rectifier circuit (40 to 49);
a flyback transformer (20), to a primary winding of which a pulse voltage obtained by switching an output voltage of the direct-current main circuit formed by the series circuits of the four capacitors (7a to 7d) is applied; and
an inverter transformer (21) including a primary winding and four secondary windings, a pulse voltage obtained by switching an output voltage of one rectifier circuit (37) among rectifier circuits (34, 36, 37) respectively connected to a plurality of secondary windings of the flyback transformer (20) being applied to the primary winding and a primary winding of each one of the isolation transformers (22, 23, 24, 25) being connected to each of the four secondary windings, wherein reference potentials of the plurality of semiconductor driving circuits (50 to 59),
reference potential of a semiconductor driving circuit (53) for a switching element (D1), one signal terminal of which is connected to the negative electrode bus (N), among the four switching elements in the unit configuration is potential at a connection end (62) of the negative electrode bus (N);
reference potential of a semiconductor driving circuit (52; 56; 59) for the second switching element (C1; C2; C3) from the negative electrode bus (N) to the positive electrode bus (P) is potential at a connection end (61) of two main circuit capacitors (7c, 7d) connected in series on the negative electrode bus side among the four main circuit capacitors;
reference potential of a semiconductor driving circuit (51; 55; 58) for the third switching element (B1; B2; B3) from the negative electrode bus (N) to the positive electrode bus (P) is potential at a connection end (8) of a series circuit of two main circuit capacitors (7a, 7b) connected in series on the positive electrode bus side and a series circuit of two main circuit capacitors (7c, 7d) connected in series on the negative electrode bus side among the four main circuit capacitors;
reference potential of a semiconductor driving circuit (50; 54; 57) for the fourth switching element (A1; A2; A3) from the negative electrode bus (N) to the positive electrode bus (P) is potential at a connection end (60) of two main circuit capacitors (7a, 7b) connected in series on the positive electrode bus side among the four main circuit capacitors;
the connection end (62) of the negative terminal side of the series circuit of the four main circuit capacitors and the negative electrode bus (N) are connected to one end of a primary winding of the isolation transformer (25) corresponding to a semiconductor driving circuit (53) for a switching element (D1), one signal terminal of which is connected to the negative electrode bus (N), among the four switching elements in the unit configuration;
the connection end (61) of the two main circuit capacitors (7c, 7d) connected in series on the negative electrode bus side among the four main circuit capacitors is connected to one end of a primary winding of the isolation transformer (24; 28; 31) corresponding to the semiconductor driving circuit (52; 56; 59) for the second switching element (C1; C2; C3) from the negative electrode bus (N) to the positive electrode bus (P) among the four switching elements in the unit configuration;
the connection end (8) of the series circuits of the two main circuit capacitors (7b, 7c) connected in series on the positive electrode bus side and the negative electrode bus side among the four main circuit capacitors is connected to one end of the primary winding of the isolation transformer (23; 27; 30) corresponding to the semiconductor driving circuit (51; 55; 58) for the third switching element (B1; B2; B3) from the negative electrode bus (N) to the positive electrode bus (P) among the four switching elements in the unit configuration; and
the connection end (60) of the two main circuit capacitors (7a, 7b) connected in series on the positive electrode bus side among the four main circuit capacitors is connected to one end of the primary winding of the isolation transformer (22; 26; 29) corresponding to the semiconductor driving circuit (50; 54; 57) for the fourth switching element (A1; A2; A3) from the negative electrode bus (N) to the positive electrode bus (P) among the four switching elements in the unit configuration.

2. The power conversion apparatus according to claim 1, wherein a connection line of a winding finish end of the secondary winding of the inverter transformer (21) and winding finish ends of the primary windings of the pulse transformers (22 to 31) is grounded via a capacitor.

## Patentansprüche

1. Stromwandler, Folgendes aufweisend:
vier Hauptschaltungskondensatoren (7a bis 7d), die zwischen einer positiven Anschlussseite und einer negativen Anschlussseite einer Gleichstromhauptschaltung (1) in Reihe geschaltet sind, um sich eine Umwandlungsziel-Gleichspannung gleich zu teilen, die von der Gleichstromhauptschaltung (1) ausgegeben wird, um die Gleichspannung gleich in vier Teile zu teilen;
einen dreistufigen Inverterschaltkreis (6) mit mindestens einer Einheitsanordnung, wobei die Einheitsanordnung enthält:
vier Schaltelemente (A1, B1, C1, D1; A2, B2, C2, D1; A3, B3, C3, D1), die in Reihe zwischen einem positiven Elektrodenbus (P) und einem negativen Elektrodenbus (N) geschaltet sind, die an eine positive Anschlussseite und eine negative Anschlussseite einer Reihenschaltung aus den vier Hauptschaltungskondensatoren (7a bis 7d) und zwischen den vier Schaltelementen und den vier Hauptschaltungskondensatoren angeschlossen sind,
eine Diode für eine obere Zweigklemme (11; 12; 13), die zwischen einem Verbindungsende (8) von Reihenschaltungen aus zwei Hauptschaltungskondensatoren auf der positiven Elektrodenbusseite (7a, 7b) und der negativen Elektrodenbusseite (7c, 7d) und einem Verbindungsende von zwei Schaltelementen (A1, B1; A2, B2; A3, B3) angeordnet ist, die auf der positiven Elektrodenbusseite in Reihe geschaltet sind, und
eine Diode für eine untere Zweigklemme (14; 15; 16), die zwischen dem Verbindungsende (8) der Reihenschaltungen aus den zwei Hauptschaltungskondensatoren auf der positiven Elektrodenbusseite (7a, 7b) und der negativen Elektrodenbusseite (7c, 7d) und einem Verbindungsende von zwei Schaltelementen (C1, D1; C2, D1; C3, D1) angeordnet ist, die auf der negativen Elektrodenbusseite in Reihe geschaltet sind,
wobei ein Verbindungsende von Reihenschaltungen, die durch zwei Schaltelemente (B1, C1; B2, C2; B3, C3) auf der positiven Elektrodenbusseite und der negativen Elektrodenbusseite gebildet sind, als Inverterausgangsende ausgebildet ist;
mehrere Halbleitertreiberschaltungen (50 bis 59), die dazu konfiguriert sind, mehrere der Schaltelemente in dem dreistufigen Inverterschaltkreis (6) anzusteuern, wobei eine Halbleitertreiberschaltung (53) für das Schaltelement (D1), wovon ein Signalanschluss an den negativen Elektrodenbus (N) angeschlossen ist, von den vier Schaltelementen in der Einheitsanordnung gemeinsam bereitgestellt wird, auch wenn mehrere der Einheitsanordnungen vorgesehen sind, und die Halbleitertreiberschaltungen (50, 51, 52 ; 54, 55, 56 ; 57, 58, 59) für ein zweites bis viertes Schaltelement (A1, B1, C1 ; A2, B2, C2 ; A3, B3, C3) vom negativen Elektrodenbus zum positiven Elektrodenbus einzeln in einem Eins-zu-Eins-Verhältnis bereitgestellt werden, auch wenn mehrere der Einheitsanordnungen vorgesehen sind;
mehrere Impulstransformatoren (22 bis 31), bei denen es sich um Isoliertransformatoren handelt, die in einem Eins-zu-Eins-Verhältnis mit jeweils den mehreren Halbleitertreiberschaltungen (50 bis 59) vorgesehen sind, wobei jede der Halbleitertreiberschaltungen (50 bis 59), die einer Sekundärwicklung jeweils der Isoliertransformatoren von den mehreren Halbleitertreiberschaltungen (50 bis 59) entspricht, über eine Gleichrichterschaltung (40 bis 49) an die Sekundärwicklung angeschlossen ist;
einen Rücklauftransformator (20), wobei an eine Primärwicklung von diesem eine Impulsspannung angelegt wird, die erhalten wird, indem eine Ausgangsspannung der Gleichstromhauptschaltung umgeschaltet wird, die durch die Reihenschaltungen aus den vier Kondensatoren (7a bis 7d) gebildet ist; und
einen Invertertransformator (21) mit einer Primärwicklung und vier Sekundärwicklungen, wobei eine Impulsspannung, die erhalten wird, indem eine Ausgangsspannung einer Gleichrichterschaltung (37) unter Gleichrichterschaltungen (34, 36, 37) umgeschaltet wird, die jeweils an mehrere Sekundärwicklungen des Rücklauftransformators (20) angeschlossen sind, an die Primärwicklung angelegt wird, und eine Primärwicklung vom jedem einzelnen der Isoliertransformatoren (22, 23, 24, 25) an jeweils eine der vier Sekundärwicklungen angeschlossen ist, wobei Bezugspotentiale der mehreren Halbleitertreiberschaltungen (50 bis 59),
ein Bezugspotential einer Halbleitertreiberschaltung (53) für ein Schaltelement (D1), wovon ein Signalanschluss an den negativen Elektrodenbus (N) angeschlossen ist, von den vier Schaltelementen in der Einheitsanordnung, ein Potential an einem Verbindungsende (62) des negativen Elektrodenbusses (N) ist;
ein Bezugspotential einer Halbleitertreiberschaltung (52; 56; 59) für das zweite Schaltelement (C1; C2; C3) vom negativen Elektrodenbus (N) zum positiven Elektrodenbus (P) ein Potential an einem Verbindungsende (61) von zwei Hauptschaltungskondensatoren (7c, 7d) ist, die von den vier Hauptschaltungskondensatoren auf der negativen Elektrodenbusseite in Reihe geschaltet sind;
ein Bezugspotential einer Halbleitertreiberschaltung (51; 55; 58) für das dritte Schaltelement (B1; B2; B3) vom negativen Elektrodenbus (N) zum positiven Elektrodenbus (P) ein Potential an einem Verbindungsende (8) einer Reihenschaltung aus zwei Hauptschaltungskondensatoren (7a, 7b), die auf der positiven Elektrodenbusseite in Reihe geschaltet sind, und einer Reihenschaltung aus zwei Hauptschaltungskondensatoren (7c, 7d) ist, die von den vier Hauptschaltungskondensatoren auf der negativen Elektrodenbusseite in Reihe geschaltet sind;
ein Bezugspotential einer Halbleitertreiberschaltung (50; 54; 57) für das vierte Schaltelement (A1; A2; A3) vom negativen Elektrodenbus (N) zum positiven Elektrodenbus (P) ein Potential an einem Verbindungsende (60) von zwei Hauptschaltungskondensatoren (7a, 7b) ist, die von den vier Hauptschaltungskondensatoren auf der positiven Elektrodenbusseite in Reihe geschaltet sind;
das Verbindungsende (62) der negativen Anschlussseite der Reihenschaltung aus den vier Hauptschaltungskondensatoren und der negative Elektrodenbus (N) an ein Ende einer Primärwicklung des Isoliertransformators (25) angeschlossen sind, der einer Halbleitertreiberschaltung (53) für ein Schaltelement (D1), wovon ein Signalanschluss an den negativen Elektrodenbus (N) angeschlossen ist, von den vier Schaltelementen im Einheitsaufbau entspricht;
das Verbindungsende (61) der zwei Hauptschaltungskondensatoren (7c, 7d), die von den vier Hauptschaltungskondensatoren auf der negativen Elektrodenbusseite in Reihe geschaltet sind, ist an ein Ende einer Primärwicklung des Isoliertransformators (24; 28; 31) angeschlossen, das der Halbleitertreiberschaltung (52; 56; 59) für das zweite Schaltelement (C1; C2; C3) vom negativen Elektrodenbus (N) zum positiven Elektrodenbus (P) von den vier Schaltelementen im Einheitsaufbau entspricht;
das Verbindungsende (8) der Reihenschaltungen aus den zwei Hauptschaltungskondensatoren (7b, 7c), die von den vier Hauptschaltungskondensatoren auf der positiven Elektrodenbusseite und der negativen Elektrodenbusseite in Reihe geschaltet sind, ist an ein Ende der Primärwicklung des Isoliertransformators (23; 27; 30) angeschlossen, das der Halbleitertreiberschaltung (51; 55; 58) für das dritte Schaltelement (B1; B2; B3) vom negativen Elektrodenbus (N) zum positiven Elektrodenbus (P) von den vier Schaltelementen im Einheitsaufbau entspricht; und
das Verbindungsende (60) der zwei Hauptschaltungskondensatoren (7a, 7b), die von den vier Hauptschaltungskondensatoren auf der positiven Elektrodenbusseite in Reihe geschaltet sind, ist an ein Ende der Primärwicklung des Isoliertransformators (22; 26; 29) angeschlossen, das der Halbleitertreiberschaltung (50; 54; 57) für das vierte Schaltelement (A1; A2; A3) vom negativen Elektrodenbus (N) zum positiven Elektrodenbus (P) von den vier Schaltelementen im Einheitsaufbau entspricht.

2. Stromwandler nach Anspruch 1, wobei eine Anschlussleitung eines Wicklungsabschlussendes der Sekundärwicklung des Invertertransformators (21) und von Wicklungsabschlussenden der Primärwicklungen der Impulstransformatoren (22 bis 31) über einen Kondensator an Masse gelegt ist.

## Revendications

1. Appareil de conversion de puissance comprenant :
quatre condensateurs de circuit principal (7a à 7d) connectés en série entre un côté de borne positif et un côté de borne négatif d'un circuit principal à courant continu (1) pour partager de manière égale une tension de courant continu cible de conversion sortie par le circuit principal à courant continu (1) pour diviser de manière égale la tension de courant continu en quatre ;
un circuit de commutation à inverseur à trois niveaux (6) incluant au moins une configuration d'unité, la configuration d'unité incluant :
quatre éléments de commutation (A1, B1, C1, D1 ; A2, B2, C2, D1 ; A3, B3, C3, D1) connectés en série entre un bus d'électrode positif (P) et un bus d'électrode négatif (N) connectés à un côté de borne positif et un côté de borne négatif d'un circuit série des quatre condensateurs de circuit principal (7a à 7d), et entre les quatre éléments de commutation et les quatre condensateurs de circuit principal,
une diode pour une borne d'un bras supérieur (11 ; 12 ; 13) agencée entre une extrémité de connexion (8) de circuits série de deux condensateurs de circuit principal du côté de bus d'électrode positif (7a, 7b) et du côté de bus d'électrode négatif (7c, 7d) et une extrémité de connexion de deux éléments de commutation (A1, B1 ; A2, B2 ; A3, B3) connectés en série du côté de bus d'électrode positif, et
une diode pour une borne d'un bras inférieur (14 ; 15 ; 16) agencée entre l'extrémité de connexion (8) des circuits série des deux condensateurs de circuit principal du côté de bus d'électrode positif (7a, 7b) et du côté de bus d'électrode négatif (7c, 7d) et une extrémité de connexion de deux éléments de commutation (C1, D1 ; C2, D1 ; C3, D1) connectés en série du côté de bus d'électrode négatif,
une extrémité de connexion de circuits série formés par deux éléments de commutation (B1, C1 ; B2, C2 ; B3, C3) du côté de bus d'électrode positif et du côté de bus d'électrode négatif étant formée comme extrémité de sortie d'inverseur ;
une pluralité de circuits d'attaque à semiconducteur (50 à 59) configurés pour commander une pluralité d'éléments de commutation dans le circuit de commutation à inverseur à trois niveaux (6), un circuit d'attaque à semiconducteur (53) pour l'élément de commutation (D1), dont une borne de signal est connectée au bus d'électrode négatif (N), parmi les quatre éléments de commutation dans la configuration d'unité étant prévus en commun même si une pluralité des configurations d'unité sont prévues, et les circuits d'attaque à semiconducteur (50, 51, 52 ; 54, 55, 56 ; 57, 58, 59) pour un deuxième à un quatrième élément de commutation (A1, B1, C1 ; A2, B2, C2 ; A3, B3, C3) depuis le bus d'électrode négatif vers le bus d'électrode positif étant individuellement prévus dans une relation un à un même si une pluralité des configurations d'unité sont prévues ;
une pluralité de transformateurs d'impulsion (22 à 31), qui sont des transformations d'isolation, prévus dans une relation un à un avec chacun de la pluralité de circuits d'attaque à semiconducteur (50 à 59), chacun des circuits d'attaque à semiconducteur (50 à 59) correspondant à un enroulement secondaire de chacun des transformateurs d'isolation parmi la pluralité de circuits d'attaque à semiconducteur (50 à 59) étant connecté à l'enroulement secondaire via un circuit rectifieur (40 à 49) ;
un transformateur de balayage horizontal (20), vers un enroulement primaire duquel une tension d'impulsion obtenue en commutant une tension de sortie du circuit principal à courant continu formé par les circuits série des quatre condensateurs (7a à 7d) est appliquée ; et
un transformateur inverseur (21) incluant un enroulement primaire et quatre enroulements secondaires, une tension d'impulsion obtenue en commutant une tension de sortie d'un circuit rectifieur (37) parmi des circuits rectifieurs (34, 36, 37) respectivement connectés à une pluralité d'enroulements secondaires du transformateur de balayage horizontal (20) étant appliquée à l'enroulement primaire et un enroulement primaire de chacun des transformateurs d'isolation (22, 23, 24, 25) étant connecté à chacun des quatre enroulements secondaires, sachant que des potentiels de référence de la pluralité de circuits d'attaque à semiconducteur (50 à 59),
un potentiel de référence d'un circuit d'attaque à semiconducteur (53) pour un élément de commutation (D1), dont une borne de signal est connectée au bus d'électrode négatif (N), parmi les quatre éléments de commutation dans la configuration d'unité est un potentiel à une extrémité de connexion (62) du bus d'électrode négatif (N) ;
un potentiel de référence d'un circuit d'attaque à semiconducteur (52 ; 56 ; 59) pour le deuxième élément de commutation (C1 ; C2 ; C3) depuis le bus d'électrode négatif (N) vers le bus d'électrode positif (P) est un potentiel à une extrémité de connexion (61) de deux condensateurs de circuit principal (7c, 7d) connectés en série du côté de bus d'électrode négatif parmi les quatre condensateurs de circuit principal ;
un potentiel de référence d'un circuit d'attaque à semiconducteur (51 ; 55 ; 58) pour le troisième élément de commutation (B1 ; B2 ; B3) depuis le bus d'électrode négatif (N) vers le bus d'électrode positif (P) est un potentiel à une extrémité de connexion (8) d'un circuit série de deux condensateurs de circuit principal (7a, 7b) connectés en série du côté de bus d'électrode positif et d'un circuit série de deux condensateurs de circuit principal (7c, 7d) connectés en série du côté de bus d'électrode négatif parmi les quatre condensateurs de circuit principal ;
un potentiel de référence d'un circuit d'attaque à semiconducteur (50 ; 54 ; 57) pour le quatrième élément de commutation (A1 ; A2 ; A3) depuis le bus d'électrode négatif (N) vers le bus d'électrode positif (P) est un potentiel à une extrémité de connexion (60) de deux condensateurs de circuit principal (7a, 7b) connectés en série du côté de bus d'électrode positif parmi les quatre condensateurs de circuit principal ;
l'extrémité de connexion (62) du côté de borne négatif du circuit série des quatre condensateurs de circuit principal et le bus d'électrode négatif (N) sont connectés à une extrémité d'un enroulement primaire du transformateur d'isolation (25) correspondant à un circuit d'attaque à semiconducteur (53) pour un élément de commutation (D1), dont une borne de signal est connectée au bus d'électrode négatif (N), parmi les quatre éléments de commutation dans la configuration d'unité ;
l'extrémité de connexion (61) des deux condensateurs de circuit principal (7c, 7d) connectés en série du côté de bus d'électrode négatif parmi les quatre condensateurs de circuit principal est connectée à une extrémité d'un enroulement primaire du transformateur d'isolation (24 ; 28 ; 31) correspondant au circuit d'attaque à semiconducteur (52 ; 56 ; 59) pour le deuxième élément de commutation (C1 ; C2 ; C3) depuis le bus d'électrode négatif (N) vers le bus d'électrode positif (P) parmi les quatre éléments de commutation dans la configuration d'unité ;
l'extrémité de connexion (8) des circuits série des deux condensateurs de circuit principal (7b, 7c) connectés en série du côté de bus d'électrode positif et du côté de bus d'électrode négatif parmi les quatre condensateurs de circuit principal est connectée à une extrémité de l'enroulement primaire du transformateur d'isolation (23 ; 27 ; 30) correspondant au circuit d'attaque à semiconducteur (51 ; 55 ; 58) pour le troisième élément de commutation (B1 ; B2 ; B3) depuis le bus d'électrode négatif (N) vers le bus d'électrode positif (P) parmi les quatre éléments de commutation dans la configuration d'unité ; et
l'extrémité de connexion (60) des deux condensateurs de circuit principal (7a, 7b) connectés en série du côté de bus d'électrode positif parmi les quatre condensateurs de circuit principal est connectée à une extrémité de l'enroulement primaire du transformateur d'isolation (22 ; 26 ; 29) correspondant au circuit d'attaque à semiconducteur (50 ; 54 ; 57) pour le quatrième élément de commutation (A1 ; A2 ; ; A3) depuis le bus d'électrode négatif (N) vers le bus d'électrode positif (P) parmi les quatre éléments de commutation dans la configuration d'unité.

2. L'appareil de conversion de puissance selon la revendication 1, sachant qu'une ligne de connexion d'une extrémité de terminaison d'enroulement de l'enroulement secondaire du transformateur inverseur (21) et d'extrémités de terminaison d'enroulement des enroulements primaires des transformateurs d'impulsion (22 à 31) est mise à la terre via un condensateur.
